# EUROPÄISCHE PATENTSCHRIFT

(11) **EP 1 869 539 B1**
(45) Veröffentlichungstag und Bekanntmachung des Hinweises auf die Patenterteilung: **03.11.2010**
(21) Anmeldenummer: 06707396.5
(22) Anmeldetag: 03.03.2006
(51) Int. Cl.: G06F 1/20, H05K 7/20

(54) **BEDIENGEHÄUSE**
OPERATING HOUSING
BOITIER DE SERVICE

(30) Priorität: 08.04.2005 DE 102005016115
(43) Veröffentlichungstag der Anmeldung: 26.12.2007
(73) Patentinhaber: Rittal Electronic Systems GmbH & Co. KG, 35745 Herborn (DE)
(72) Erfinder: KRAMER, Tim, 35606 Solms (DE)
(74) Vertreter: Fleck, Hermann-Josef
(86) Internationale Anmeldenummer: PCT/EP2006/001932
(87) Internationale Veröffentlichungsnummer: WO 2006/105835

(56) Entgegenhaltungen:
- EP-A2- 0 036 384
- DE-A1- 10 338 469
- DE-U1-202004 017 338
- JP-A- 2003 218 571

## Beschreibung

Die Erfindung bezieht sich auf ein Bediengehäuse mit vier Seitenwänden, einer Frontwand und einer Rückwand und mit einer Kühlvorrichtung zum Abführen von Verlustwärme eingebauter elektronischer Komponenten.

Die DE 20 2004 017 338 U1 zeigt ein Bediengehäuse, mit einem von Wänden umschlossenen, kühlbaren Innenraum wobei zwei gegenüberliegende Seitenwände des Gehäuses als Innenwände von Umgebungsluft durchströmbaren Hohlkammern ausgebildet sind.

Die EP 0 036 384 A2 zeigt eine Gerätekombination für den Bergbau mit Bauelementen der Leistungselektronik, die in einem Gehäuse eingebaut sind. Eine vordere Gehäuseöffnung ist durch einen runden Deckel verschlossen, der an Schwenkarmen gehalten ist und der sich nach Aufhebung der vorgesehenen Verriegelungen durch Drehen und seitliches Schwenken öffnen lässt. An der Vorderwand befinden sich neben dem Deckel noch Betätigungshandgriffe für Trennschalter. An der einen Seitenwand ist ein plattenförmiger Kühlkörper angebracht, der den größten Teil der Seitenwand bildet und eine dort eingebrachte Öffnung des Gehäuses abdeckt. In den Kühlkörper sind als Bohrungen ausgebildete Kühlmittelkanäle eingebracht, die auf voneinander abgekehrten schmalen Rändern münden und über außen liegende bogenförmige Rohrstücke miteinander verbunden sind. Auf der Innenseite des Kühlkörpers sind durch sich rechtwinklig kreuzende rinnenartige Vertiefungen Teilflächen voneinander abgegrenzt.

Die JP 2003/218571 A zeigt ein gehäuseartiges Chassis mit vier plattenartigen Chassiswänden, in denen Kühlelemente aufgenommen sind.

In der DE 103 38 469 A1 ist ein Stromrichtermodul mit einer rückwärtigen Kühlplatte gezeigt, die von Kühlmittelkanälen durchzogen ist, welche durch stirnseitige Anschlussmittel miteinander gekoppelt sind.

Ein weiteres Bediengehäuse, wie es z.B. aus RITTAL-Handbuch 29, Seite 181 (aus dem Jahre 1997) bekannt ist, dient z.B. für die Gerätesteuerung durch eine Bedienperson und umfasst auf seiner Außenseite, insbesondere Frontseite, vielfältige Bedienelemente und mindestens eine Sichtanzeige, die vorzugsweise als flaches Anzeigefeld eines im Inneren eingebauten Computers ausgestaltet ist. Außer dem normalerweise ein eigenes Gehäuse aufweisenden Computer können im Inneren noch weitere elektrische oder elektronische Komponenten angeordnet sein. Das Bediengehäuse ist z.B. an einem Tragarm schwenkbar angebracht und relativ kompakt ausgebildet.

Der Erfindung liegt die Aufgabe zugrunde, ein Bediengehäuse der genannten Art bereitzustellen, dessen Aufbau zu einer möglichst einfachen Handhabbarkeit und Bedienbarkeit beiträgt.

Diese Aufgabe wird mit den Merkmalen des Anspruches 1 gelöst. Hierbei ist vorgesehen, dass die Kühlvorrichtung eine von Kühlflüssigkeit durchströmte Kühlplatte aufweist, die den größten Teil der Rückwand bildet. Diese Ausgestaltung der Kühlvorrichtung trägt zu einem flachen, kompakten Aufbau bei, wobei eine hohe Kühlleistung sichergestellt ist.

Ein vorteilhafter Aufbau mit einfacher Montage und großer Kühlfläche wird dadurch begünstigt, dass die Kühlplatte mit einem umlaufenden Randbereich auf eine rückseitige Öffnung des Bediengehäuses rahmenartig umgebenden Wandabschnitten von innen oder von außen angebracht ist.

Eine einfache Fertigung und sichere Funktion ohne Gefahr eines Austritts von Kühlflüssigkeit im Inneren werden dadurch unterstützt, dass in der Kühlplatte mindestens ein Kühlkanal zum Leiten der Kühlflüssigkeit eingebracht ist, der mit einem auf der Außenseite der Rückwand angeordneten Zuström- und einem Abströmanschluss versehen ist.

Für die Abführung der Verlustwärme sind weiterhin die Maßnahmen vorteilhaft, dass zum Transport der mit Verlustwärme beladenen Luft zu der Kühlplatte oder dem Kühlkörper im Inneren des Bediengehäuses mindestens ein Lüfter angeordnet ist.

Zur Bedienbarkeit bei zuverlässiger Funktion tragen die Maßnahmen vorteilhaft bei, dass in dem Bediengehäuse ein Computer mit einem in der Frontwand eingebauten Anzeigefeld aufgenommen ist, der einen in einem Computergehäuse eingebauten Lüfter aufweist, welcher zur Abführung der Luft zu der Kühlplatte oder dem Kühlkörper mit dem Inneren des Bediengehäuses in Strömungsverbindung gebracht ist. Das Computergehäuse selbst ist hierbei vorteilhaft mit Lüftungsöffnungen versehen. Die erforderliche Schutzklasse ergibt sich durch das dicht gekapselte Bediengehäuse.

Eine erhöhte Kühlleistung wird dadurch erreicht, dass auf der dem Inneren des Bediengehäuses zugekehrten Innenseite der Kühlplatte mindestens ein mit Kühlrippen oder Luftströmungskanälen versehener Kühlkörper einstückig ausgebildet oder als separates Teil aufgebracht ist, der von der mit der Verlustwärme beladenen Luft im Inneren des Bediengehäuses durchströmt wird.

Für eine effiziente Kühlung sind des Weiteren die Maßnahmen von Vorteil, dass im Inneren des Bediengehäuses ein oder mehrere Luftleitbleche eingebracht sind, mit dem oder denen die mit Verlustwärme beladene Luft entlang der Innenseite der Kühlplatte oder über den Kühlkörper geführt wird.

Eine sichere Funktion sowie günstige Fertigungsmöglichkeiten ergeben sich dadurch, dass der mindestens eine Kühlkanal mit einer eingesetzten Leitung versehen ist. Dieser Aufbau ermöglicht auch vielfältige Anpassungsmöglichkeiten an unterschiedliche Gegebenheiten.

Eine vorteilhafte Herstellung wird dabei dadurch begünstigt, dass die Leitung in mindestens einen von der flachen Seite eingefrästen, mäanderförmig verlaufenden Aufnahmekanal eingepresst ist und dass die betreffende flache Seite anschließend plan gearbeitet ist.

Die Erfindung wird nachfolgend anhand von Ausführungsbeispielen unter Bezugnahme auf die Zeichnungen näher erläutert. Es zeigen:
- Fig. 1A und 1B: ein erstes Ausführungsbeispiel eines Bediengehäuses mit einer Kühl- platte im Querschnitt und von der Rückseite in schematischer Darstel- lung,
- Fig. 2A und 2B: ein zweites Ausführungsbeispiel des Bediengehäuses mit einer Kühl- platte und einem Kühlkörper im Querschnitt und von der Rückseite,
- Fig. 3: eine schematische Ansicht einer Kühlplatte von der Rückseite und
- Fig. 4: einen ausschnittsweisen Querschnitt der Kühlplatte.

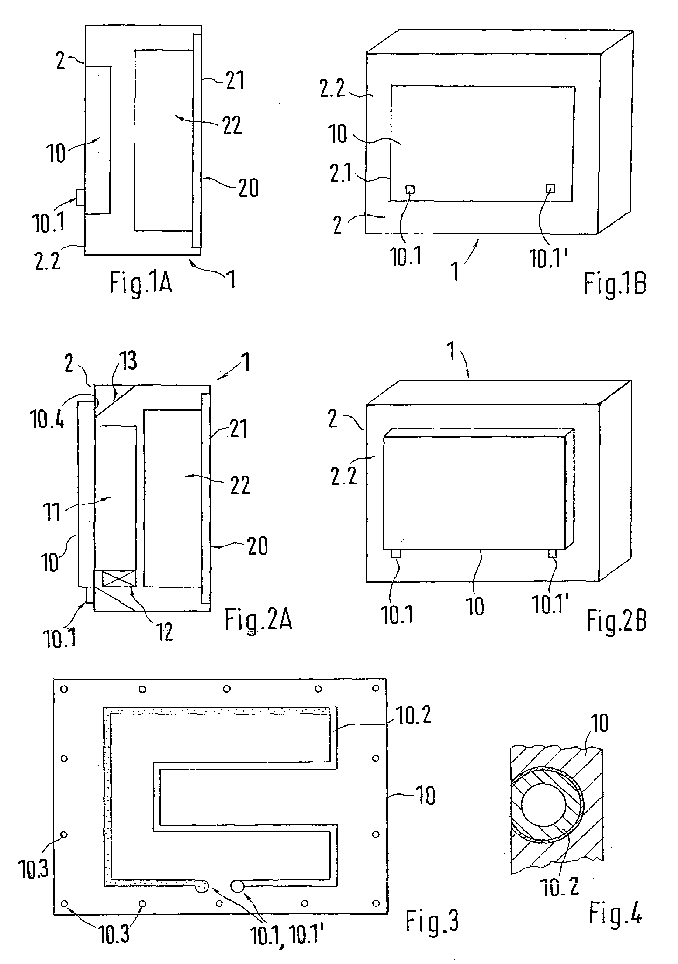

Fig. 1A und 1B zeigen ein Bediengehäuse 1 mit einer mit einer Kühlplatte 10 versehenen Rückwand 2. Die Kühlplatte 10 ist von der Innenseite des Bediengehäuses 1 her an der Rückwand 2 angebracht und steht lediglich etwas ins Innere des Bediengehäuses vor. Außen ist die Rückwand 2 bis auf einen Zuströmanschluss 10.1 und einen Abströmanschluss 10.1' flach ausgebildet. Die Kühlplatte 10 liegt dabei auf der Außenseite bis auf einen Randbereich 10.4 frei, der in eine rückseitige Öffnung 2.1 umlaufend umgebenden Wandabschnitten 2.2 flanschartig anliegt und vorzugsweise mittels Schrauben befestigt ist, die in Befestigungslöcher 10.3 (vgl. Fig. 3) bzw. Gewindebohrungen von der Rückseite her eingreifen. Wischen dem Randbereich 10.4 der Kühlplatte 10 und den Wandabschnitten 2.2 sind vorteilhaft Dichtmittel eingebracht, um eine hohe Schutzklasse des vorteilhafterweise bis auf eventuelle Zuführstellen von Kabeln bzw. einer Anbringöffnung eines Tragarmes vollständig gekapselten Bediengehäuses 1 zu erhalten. In dem Bediengehäuse 1 ist ein Einbau-Computer 20 mit einem relativ flachen eigenen Computergehäuse 22 eingebaut, der auf der Frontseite des Bediengehäuses 1 mit einem großflächigen Anzeigefeld 21 versehen ist. Das Anzeigefeld 21 ist seinerseits an einem umlaufenden Rand der Frontwand abgedichtet angebracht. Auf der Frontseite sind in der Regel verschiedene Handbedienelemente angeordnet, die stattdessen aber beispielsweise auch oder ergänzenden einem an der Unterseite des Bediengehäuses 1 nach vorne vorstehend angebrachten zusätzlichen Bedienteil angeordnet sein können. Im Bediengehäuse 1 können noch weitere elektrische oder elektronische Komponenten untergebracht sein.

Bei dem in den Fig. 2A und 2B gezeigten Ausführungsbeispiel ist die Kühlplatte 10 mit ihrem Randbereich 10.4 von außen an den Wandabschnitten 2.2 angebracht und ragt mit einem oder mehreren Kühlkörpern 11, der oder die mehrere vorzugsweise vertikal verlaufende Kühlrippen oder Kühlkanäle für Kühlluft aufweisen, in das Innere des Bediengehäuses 1. Am unteren Rand des Kühlkörpers 11 sind ein oder mehrere Lüfter 12 angeordnet, um mit Verlustwärme beladene Luft durch den Kühlkörper 11 zu führen und somit die Verlustwärme an die von einer Kühlflüssigkeit durchströmte Kühlplatte 10 abzugeben. Der Kühlkörper 11 kann direkt an der Kühlplatte 10 einstückig angeformt sein oder als mindestens ein separates Element auf diesem gut wärmeleitend angebracht sein. Der mindestens eine Lüfter 12 kann alternativ auch am oberen Randbereich des Kühlkörpers 11 positioniert sein und ist jedenfalls so angeordnet, dass er die durch die elektronischen Komponenten erwärmte Luft ansaugt und durch den Kühlkörper 11 bzw., wenn dieser nicht vorhanden ist, direkt entlang der Innenseite der Kühlplatte 10 führt. Um die Luftführung zu verbessern, können, wie Fig. 2A weiterhin zeigt, im inneren des Bediengehäuses 1 Luftleitbleche 13 in geeigneter Anordnung eingebracht sein, um einen möglichst guten Kühleffekt zu erzielen. Nach Fig. 2A sind Kühlleitbleche 13 beispielhaft im unteren und oberen hinteren Winkelbereich des Bediengehäuses 1 schräg angeordnet, um eine gute Luftzirkulation zu gewährleisten. Die Kühlplatte 10 ist ebenfalls in ihrem unteren Randbereich mit einem Zuström- und einem Abströmanschluss 10.1 bzw. 10.1' versehen.

Wie in Fig. 3 schematisch dargestellt, sind im Inneren der Kühlplatte 10 mäanderförmig verlaufende Kühlkanäle ausgebildet, die mehr oder weniger dicht, je nach gewünschter Kühlleistung geführt sein können. Wie in der Querschnittsdarstellung in Fig. 4 gezeigt, ist die Ausgestaltung der Kühlkanäle in der Weise vorgenommen, dass von der einen flachen Seite der Kühlplatte 10, die beispielsweise die Rückseite der Rückwand 2 bildet, zunächst nutartige Kanäle eingefräst sind, in die eine oder mehrere Kühlleitungen 10.2 eingepresst sind, um einerseits einen guten Wärmekontakt der an sich ebenfalls gut wärmeleitfähigen Kühlleitungen 10.2 und außerdem eine sichere Befestigung zu gewährleisten. Die Öffnung des nutartigen Kanals zur flachen Seite hin ist schmäler als ihr Inneres, so dass die eingedrückte Kühlleitung 10.2 sicher gehalten ist. Überstände der Kühlleitung 10.2 auf der flachen Außenseite der Kühlplatte 10 werden nach ihrem Einbringen plan gearbeitet, wozu die Kühlleitungen 10.2 einen ausreichend dicken Wandbereich besitzen. Ferner werden entstehende Lücken oder Unebenheiten z.B. mittels Leitklebers oder ähnlicher geeigneter Materialien verfüllt und geglättet. Nach Fig. 3 sind der Zuström- und Abströmanschluss 10.1, 10.1' im unteren mittleren Bereich der Kühlplatte 10 in der Nähe voneinander angeordnet, so dass sich eine zuführende und abführende Leitung nahe benachbart zueinander anschließen lassen. Die Kühlflüssigkeit wird über den Zuström- und Abströmanschluss 10.1, 10.1' von bzw. zu einer entfernten Kühleinrichtung geführt, beispielsweise einer Rückkühlanlage, um dort die Wärme abzuführen bzw. von dort wieder gekühlte Flüssigkeit zuzuführen. Die Umgebung des Bediengehäuses 1 wird somit über die Kühlplatte 10 kaum mit zusätzlicher Wärme belastet; im Inneren des Bediengehäuses 1 hingegen ergibt sich eine hohe Kühlleistung. Für die Kühlplatte 10, den Kühlkörper 11 sowie die Leitung 10.2 werden gut wärmeleitende Metalle, insbesondere Kupfer und/oder Aluminium verwendet.

## Patentansprüche

1. Bediengehäuse mit vier Seitenwänden, einer Frontwand und einer Rückwand (2) und mit einer Kühlvorrichtung zum Abführen von Verlustwärme eingebauter elektronischer Komponenten, die eine von Kühlflüssigkeit durchströmte Kühlplatte (10) aufweist, die den größten Teil einer Wand (2) bildet und mit einem umlaufenden Randbereich (10.4) auf eine Öffnung (2.1) der Wand des Bediengehäuses (1) rahmenartig umgebenden Wandabschnitten (2.2) von innen oder von außen angebracht ist, wobei in der Kühlplatte (10) mindestens ein Kühlkanal zum Leiten der Kühlflüssigkeit eingebracht ist, der mit einem auf der Außenseite der Rückwand (2) angeordneten Zuström- und einem Abströmanschluss (10.1, 10.1') versehen ist,
wobei
die Kühlplatte (10) auf einer Rückwand (2) des Bediengehäuses (1) angeordnet ist,
wobei zum Transport der mit Verlustwärme beladenen Luft zu der Kühlplatte (10) im Inneren des Bediengehäuses (1) mindestens ein Lüfter (12) angeordnet ist und
wobei in dem Bediengehäuse (1) ein Computer (20) mit einem in der Frontwand eingebauten Anzeigefeld (21) aufgenommen ist, der einen in einem Computergehäuse (22) eingebauten Lüfter aufweist, welcher zur Abführung der Luft zu der Kühlplatte (10) mit dem Inneren des Bediengehäuses in Strömungsverbindung gebracht ist.

2. Bediengehäuse nach Anspruch 1,
**dadurch gekennzeichnet,**
**dass** auf der dem Inneren des Bediengehäuses (1) zugekehrten Innenseite der Kühlplatte (10) mindestens ein mit Kühlrippen oder Luftströmungskanälen versehener Kühlkörper (11) einstückig ausgebildet oder als separates Teil aufgebracht ist, der von der mit der Verlustwärme beladenen Luft im Inneren des Bediengehäuses (1) durchströmt wird.

3. Bediengehäuse nach einem der vorhergehenden Ansprüche,
**dadurch gekennzeichnet,**
**dass** im Inneren des Bediengehäuses (1) ein oder mehrere Luftleitbleche (13) eingebracht sind, mit dem oder denen die mit Verlustwärme beladene Luft entlang der Innenseite der Kühlplatte (10) oder über den Kühlkörper (11) geführt wird.

4. Bediengehäuse nach einem der vorhergehenden Ansprüche,
**dadurch gekennzeichnet,**
**dass** der mindestens eine Kühlkanal mit einer eingesetzten Leitung (10.2) versehen ist.

5. Bediengehäuse nach Anspruch 4,
**dadurch gekennzeichnet,**
**dass** die Leitung (10.2) in mindestens einen von der flachen Seite eingefrästen, mäanderförmig verlaufenden Aufnahmekanal eingepresst ist und dass die betreffende flache Seite anschließend plan gearbeitet ist.

## Claims

1. Operator control housing having four side walls, a front wall and a rear wall (2) and having a cooling apparatus for dissipating heat lost from incorporated electronic components, which cooling apparatus has a cooling plate (10) through which cooling liquid flows, said cooling plate forming the major part of a wall (2) and, by way of a peripheral edge region (10.4), being mounted from the inside or from the outside on an opening (2.1) in the wall of the operator control housing (1) so as to surround wall sections (2.2) in a frame-like manner, with at least one cooling duct for conducting the cooling liquid being introduced into the cooling plate (10), the said cooling duct being provided with an inflow and an outflow connection (10.1, 10.1') on the outer face of the rear wall (2), with
the cooling plate (10) being arranged on a rear wall (2) of the operator control housing (1),
with at least one fan (12) being arranged in the interior of the operator control housing (1) for the purpose of transporting the air which is laden which lost heat to the cooling plate (10),
with a computer (20) with a display panel (21) incorporated in the front wall being accommodated in the operator control housing (1), the said computer having a fan which is incorporated in a computer housing (22) and which forms a flow connection with the interior of the operator control housing in order to discharge the air to the cooling plate (10).

2. Operator control housing according to Claim 1,
**characterized**
**in that** at least one heat sink (11) which is provided with cooling ribs or air flow ducts is integrally formed on the inner face of the cooling plate (10), the said inner face facing the interior of the operator control housing (1), or is mounted on the said inner face as a separate part through which the air which is laden with the lost heat flows in the interior of the operator control housing (1).

3. Operator control housing according to either of the preceding claims,
**characterized**
**in that** one or more air guide plates (13) are incorporated in the interior of the operator control housing (1), the air which is laden with the lost heat being guided along the inner face of the cooling plate (10) or over the heat sink (11) by the said air guide plate or plates.

4. Operator control housing according to one of the preceding claims,
**characterized**
**in that** the at least one cooling duct is provided with an inserted line (10.2).

5. Operator control housing according to Claim 4,
**characterized**
**in that** the line (10.2) is pressed into at least one meandering accommodation duct which is milled in from the flat face, and in that the flat face in question is then machined to be planar.

## Revendications

1. Boîtier de service avec quatre parois latérales, une paroi avant et une paroi arrière (2) et avec un dispositif de refroidissement pour évacuer la chaleur perdue de composants électroniques installés, qui présente une plaque de refroidissement (10) parcourue par un liquide de refroidissement qui forme la plus grande partie d'une paroi (2) et qui est appliquée de l'intérieur ou de l'extérieur par une zone de bord périphérique (10.4) sur des parties de paroi (2.2) entourant en forme de cadre une ouverture (2.1) de la paroi du boîtier de service (1), dans lequel au moins un canal de refroidissement destiné à conduire le liquide de refroidissement est pratiqué dans la plaque de refroidissement (10), lequel est pourvu d'un raccord d'alimentation et d'un raccord d'évacuation (10.1, 10.1') disposés sur la face extérieure de la paroi arrière (2), dans lequel la plaque de refroidissement (10) est disposée sur une paroi arrière (2) du boîtier de service (1), dans lequel au moins un ventilateur (12) est disposé à l'intérieur du boîtier de service (1) pour le transport de l'air chargé de la chaleur perdue vers la plaque de refroidissement (10), et dans lequel un ordinateur (20) avec un champ d'affichage (21) intégré dans la paroi avant est logé dans le boîtier de service (1) et présente un ventilateur intégré dans un boîtier d'ordinateur (22), qui est mis en relation d'écoulement avec l'intérieur du boîtier de service pour l'évacuation de l'air vers la plaque de refroidissement (10).

2. Boîtier de service selon la revendication 1, **caractérisé en ce qu'**au moins un corps de refroidissement (11), pourvu d'ailettes de refroidissement ou de canaux de circulation d'air, est formé d'une seule pièce ou est appliqué comme pièce séparée sur la face intérieure de la plaque de refroidissement (10) tournée vers l'intérieur du boîtier de service (1), lequel corps est parcouru à l'intérieur du boîtier de service (1) par l'air chargé de la chaleur perdue.

3. Boîtier de service selon l'une quelconque des revendications précédentes, **caractérisé en ce qu'**un ou plusieurs déflecteurs d'air (13) est/sont disposé(s) à l'intérieur du boîtier de service (1), avec lequel/lesquels l'air chargé de la chaleur perdue est guidé le long de la face intérieure de la plaque de refroidissement (10) ou sur le corps de refroidissement (11).

4. Boîtier de service selon l'une quelconque des revendications précédentes, **caractérisé en ce que** ledit au moins un canal de refroidissement est pourvu d'une conduite insérée (10.2).

5. Boîtier de service selon la revendication 4, **caractérisé en ce que** la conduite (10.2) est poussée à la presse dans au moins un canal de réception s'étendant de façon sinueuse et fraisé à partir de la face plate et **en ce que** la face plate concernée est ensuite aplanie par usinage.
